# EUROPEAN PATENT SPECIFICATION

(11) **EP 2 302 109 B1**
(45) Date of publication and mention of the grant of the patent: **16.04.2014**
(21) Application number: 09828810.3
(22) Date of filing: 20.11.2009
(51) Int. Cl.: C30B 29/06, C30B 15/02

(54) **CRYSTAL GROWING METHOD**
KRISTALLZÜCHTUNGSVERFAHREN
PROCÉDÉ DE CRISTALLOGENÈSE

(30) Priority: 25.11.2008 JP 2008300253
(43) Date of publication of application: 30.03.2011
(73) Proprietor: Mitsubishi Materials Techno Corporation, Tokyo 102-8205 (JP)
(72) Inventor: Horioka,Yukichi, Chiba 2780022 (JP)
(74) Representative: Plougmann & Vingtoft A/S
(86) International application number: PCT/JP2009/006257
(87) International publication number: WO 2010/061560

(56) References cited:
- FR-A1- 2 869 028
- JP-A- 1 286 987
- JP-A- 7 277 871
- JP-A- 52 058 080
- JP-A- 56 092 193
- JP-A- 2000 264 773
- US-A- 3 658 119
- US-A- 4 036 595
- US-A- 4 454 096
- US-A- 5 993 540
- US-A1- 2005 279 276

## Description

### TECHNICAL FIELD

The present invention relates to a crystal growing method for silicon used as semiconductor materials and solar cells.

### BACKGROUND ART

As a method of growing a silicon crystal used for semiconductors, a Czochralski method (CZ method) or a vertical gradient freezing method (VGF method) has been widely used. The CZ method or the vertical gradient freezing method (VGF method) is excellent in growing a large-diameter crystal, but is problematic from the viewpoint of energy and resource saving. One of those problems is frequent replacement of a quartz crucible, for example, after every batch. That is, in the CZ method or the vertical gradient freezing method (VGF method), a polycrystalline silicon filled in the quartz crucible is melted, and a silicon crystal is produced from the melt thereof. However, the inner surface of the quartz crucible deteriorates because it is exposed to the high-temperature siliconmelt. For this reason, the quartz crucible needs to be replaced after production of every one or several silicon crystals.

Therefore, there has been proposed a method of reducing the frequency of the replacement of the quartz crucible by suppressing the deterioration of the quartz crucible or increasing the number of silicon crystals that can be produced from one quartz crucible. Then, in connection with this type of method, Japanese Patent Application Laid-Open (JP-A) No. 2000-247788 (Patent Document 1) discloses a silicon single crystal producing method and JP-A No. 2004-338978 (Patent Document 2) discloses a silicon single crystal pulling-up method.

According to the production method disclosed in Patent Document 1, a magnetic field is applied to the silicon melt in the quartz crucible to suppress the deterioration of the inner surface of the quartz crucible, which expands the life span of the quartz crucible. Accordingly, it is possible to reliably extend the lifetime of the quartz crucible, during which the silicon crystal can be produced stably, to 100 hours or more.

Further, according to the silicon single crystal pulling-up method disclosed in Patent Document 2, the silicon crystal may be continuously pulled up by repeatedly refilling a raw material into one quartz crucible without repeating an operation of opening a pull-up chamber and extracting the crystal whenever the pull-up operation ends as in the existing refilling method that has been conducted from the past. Furthermore, operations of opening and closing a gate valve and an operation of extracting a pull-up crystal that have been conducted from the past every after the crystal pull-up operation may be omitted. Thus, the operation rate of the crystal growing apparatus may be increased compared with the existing crystal growing apparatus and the contamination of the inside of the furnace resulting from the opening/closing operation and the extracting operation may be prevented. Accordingly, a pull-up operation may be performed with a high yield.
[Patent Document 1] JP-A No. 2000-247788
[Patent Document 2] JP-A No. 2004-338978

US 4 036 595 A discloses crystal growing furnace is provided wherein the molten material in the crucible is replaced constantly as it is withdrawn by a monitoring system which automatically maintains the level in the crucible at a desired point.

US 4 454 096 A discloses several embodiments of a replenishment arrangement for furnishing molten semiconductor material to furnaces for growing monocrystalline boules are described.

FR 2 869 028 A1 discloses the invention relates to an installation (10) for the production of blocks of a semiconductor material, consisting of: first chamber (12, 14), a purification system (46) one second chamber (14) which is connected to the first chamber.

US 2005/0279276 disclose a method of charging a crystal forming apparatus with molten source material is provided. The method includes the steps of positioning a melter assembly relative to the crystal forming apparatus for delivering molten silicon to a crucible of the apparatus.

US 3,658,119 A discloses a method and apparatus are described for producing a solidified metal product.

US5993540 A discloses that reactive gas is released through a crystal source material and carry the impurities away as gaseous products or as precipitates or in light or heavy form. The gaseous products are removed by vacuum and the heavy products fall to the bottom of the melt. Light products rise to the top of the melt. After purifying, dopants are added to the melt. The melt moves away from the heater and the crystal is formed.

The abovementioned references do not mention about bumping of raw material.

### DISCLOSURE OF THE INVENTION

### PROBLEMS TO BE SOLVED BY THE INVENTION

Since the quartz is a hard mineral, use of the quartz for a long period of time is theoretically possible due to its mechanical strength, and it is also a social demand for the quartz to be able to be used for a longer period of time. However, the quartz crucible is used in the highest temperature range during the step of producing the crystal as long as there is a time that the quartz crucible holds the silicon of the melting temperature therein. For this reason, it is frequent that erosion prominently occurs in the quartz at the boundary face against the silicon melt, and particularly, at the portion that is in contact with the surface of the melt. As a result, even in the methods disclosed in Patent Document 1 and 2, the frequency of the replacement of the quartz crucible may not be sufficiently reduced.

On the other hand, in addition to the problem of the frequent replacement of the quartz crucible, the existing methods have further problem of poor operation rate. For example, in the VGF method of causing the vertical gradient freezing for use in solar cells, there are problems that the crystal growth cannot be performed while the silicon is being melted when producing the crystal, which makes the melting time wasteful. Further, the vertical gradient freezing method (VGF method) has further problems in that there is a likeliness that the large crucible deforms or breaks during the melting and insoluble materials cannot be removed.

Therefore, an object of the invention is to provide a crystal growing method capable of enabling use of a quartz crucible for a longer period of time and improving operation rates of the quartz crucible. Further, another object of the invention is to improve the vertical gradient freezing method (VGF method) such that the safety and the operation rate of a furnace is improved by forming a melt in advance and supplying the melt to the large crucible so as to suppress the deformation or the breaking of the crucible and the crystal growth is performed after insoluble materials are removed from the melt.

### MEANS FOR SOLVING THE PROBLEMS

A crystal growing apparatus according to the disclosure includes a crystal growing furnace equipped with a quartz crucible, a raw material melting furnace, and a supply unit configured to repeatedly supply a molten raw material from the raw material melting furnace to the quartz crucible.

The crystal growing furnace may include a supply port which allows supply of the molten raw material thereinto and may be configured to be movable close to or away from the raw material melting furnace.

A plurality of the crystal growing furnaces may be disposed around the raw material melting furnace.

The raw material melting furnace may include an insoluble material separating unit.

A crystal growing method according to claim 1, the invention includes supplying a molten raw material to a quartz crucible.

In the crystal growing method of the invention, an insoluble material may be removed from the molten raw material before the supplying.

### EFFECTS OF THE INVENTION

According to the crystal growing method of the invention, since the quartz crucible is not used to melt the raw material for crystal production, and is just used to receive the molten raw material melted in advance, the inner surface of the quartz crucible is not damaged. That is, since the polycrystalline raw material does not need to be melted at a temperature approximately close to a softening point of the quartz, even the deformation of the quartz is small. Further, the existing refilling method involves the wasteful time of melting the solid raw material of silicon. However, according to the current operation, the crystal growth operation progresses in a short time, the quartz crucible may be used for a longer period of time, and the operation rate may be improved.

Further, when the insoluble material accompanied by impurities are removed before the molten raw material is charged into the quartz crucible, the defect of the crystal caused by the mixture of the insoluble material with the molten raw material may be prevented even when the raw material is recycled. Accordingly, the quality degradation and the collapse of the crystal caused by the insoluble material in the raw material may be reduced, and a low-cost raw material may be used. Further, the quartz crucible may be used for a longer period of time.

Furthermore, according to the crystal growing apparatus of the disclosure, when the crystal growing furnace includes the supply port movable close to or away from the raw material melting furnace, the crystal growing furnace and the raw material melting furnace are coupled to each other only when the molten raw material is supplied to the quartz crucible, and are separated from each other in other cases. Accordingly, the pressure of the crystal growing furnace may be managed more accurately, and the quartz furnace may be used for a longer period of time.

Moreover, when a plurality of the crystal growing furnaces each having the supply port movable close to or away from the raw material melting furnace is disposed around the raw material melting furnace, the plurality of crystal growing furnaces may be operated simultaneously, which further improves the operation rate of the entire apparatus.

### BRIEF DESCRIPTION OF THE DRAWINGS

Fig. 1 is a side view schematically illustrating a configuration of a crystal growing apparatus according to the disclosure in the state where a crystal pull-up furnace and a raw material melting furnace are coupled to each other;
Fig. 2 is a plan view illustrating an arrangement relationship between the crystal pull-up furnace and the raw material melting furnace; and
Fig. 3 is a side view schematically illustrating a configuration a crystal growing apparatus according to another embodiment of the disclosure in the state where a crystal pull-up furnace and a raw material melting furnace are coupled to each other.

### DESCRIPTION OF LETTERS AND SIGNS

- 1: :: quartz crucible
- 2, 12: :: vacuum chamber
- 3: :: molten raw material
- 4: :: crystal
- 5: :: main gate valve
- 6: :: sub-gate valve
- 7: :: pull-up mechanism
- 10: :: raw material melting furnace
- 11: :: melting crucible
- 13: :: hopper
- 14: :: supply path
- 15: :: gate valve
- 20: :: supply device
- 21: :: hose-structure portion
- 22: :: supply tube
- 23: :: trestle
- 30: :: guide
- 31: :: monitor window

### BEST MODE FOR CARRYING OUT THE INVENTION

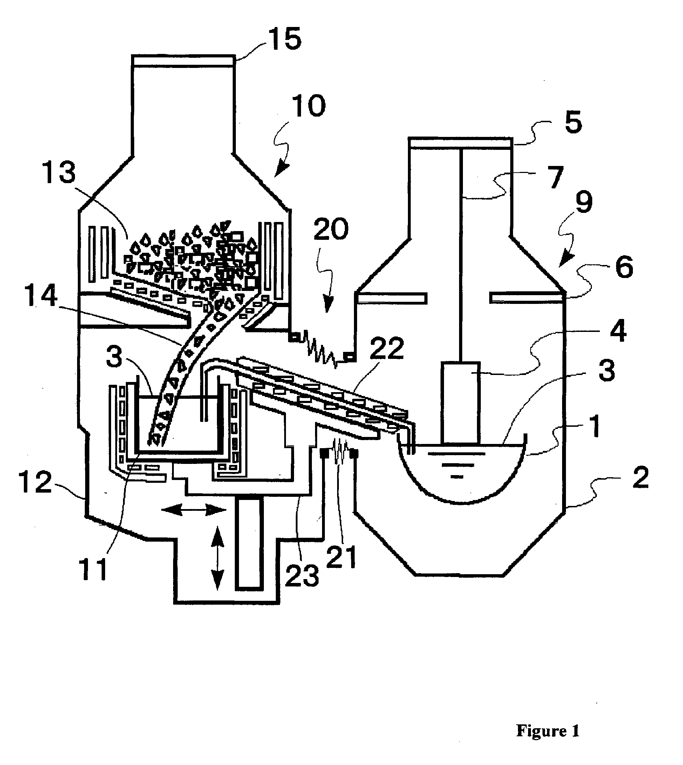

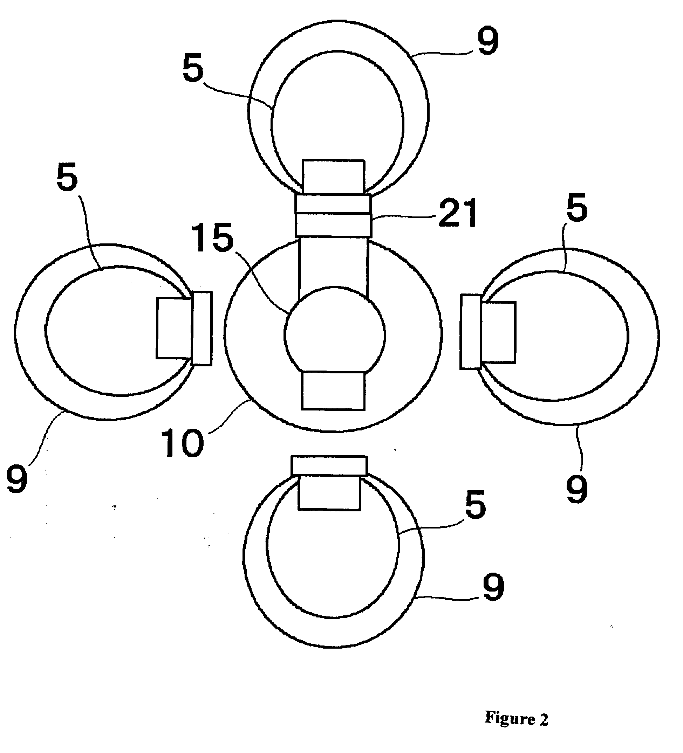

Figs. 1 and 2 schematically illustrate a configuration of a main part of a crystal growing apparatus according to the disclosure. Fig. 1 is a side view illustrating a crystal pull-up furnace and a raw material melting furnace coupled to each other, and Fig. 2 is a plan view illustrating an arrangement relationship between the crystal pull-up furnace and the raw material melting furnace. In addition, for convenience of ease of description for better understanding on the schematic configuration of the apparatus, the size or the shape of each of components is appropriately adjusted in the respective drawings, and may not identical in the respective drawings.

The apparatus includes four crystal pull-up furnaces 9 that pull up a crystal based on CZ method. Each of the crystal pull-up furnaces 9 includes a quartz crucible 1 and a vacuum chamber 2 that accommodates the quartz crucible 1 therein. Each crystal pull-up furnace is configured to hold a molten raw material 3 therein and pull up a crystal 4 under the presence of an inert gas such as He or Ar. The vacuum chamber 2 is provided with a main gate valve 5 and a sub-gate valve 6 which are opened or closed whenever the pulled-up crystal 4 is extracted or a raw material is charged into the quartz crucible 1. Further, a pull-up mechanism 7 for the crystal 4 is provided inside the vacuum chamber 2.

In addition, the apparatus includes a raw material melting furnace 10. The raw material melting furnace 10 includes a melting crucible 11 and a vacuum chamber 12 that accommodates the melting crucible 11 therein. The raw material melting furnace may melt a raw material for the crystal by the melting crucible 11 under the presence of an inert gas such as He or Ar. In addition, a hopper 13 is provided above the melting crucible 11 to supply a solid raw material (polycrystalline silicon or the like) to the melting crucible 11, and the solid raw material is supplied to the melting crucible 11 via a supply path 14 extending from the lower portion of the hopper 13. On the other hand, the vacuum chamber 12 of the raw material melting furnace 10 is provided with a gate valve 15 used for filling the solid raw material therethrough, and the raw material is supplemented via the gate valve 15 when the amount of the solid raw material inside the hopper is small. Further, the gate valve 15 has an air lock structure (not shown) so that the atmosphere inside the furnace does not deteriorate during the raw material supplement.

As shown in Fig. 2, the crystal pull-up furnaces 9 are arranged around the raw material melting furnace 10 at the same intervals. A supply device 20 for the molten raw material 3 is provided between the respective crystal pull-up furnaces 9 and the raw material melting furnace 10. The supply device 20 includes a hose-structure portion 21 which air-tightly couples the crystal pull-up furnaces 9 to the raw material melting furnace 10, and a supply tube 22 which extends from the melting crucible 3 inside the hose-structure portion 21 to the quartz crucible 1. The supply tube 22 is a tube obtained by winding a heating coil on the outer periphery of a transparent quartz tube and the resulting structure with a heat insulator, and is supported by a trestle 23 so as to be movable in the vertical direction and the horizontal direction inside the raw material melting furnace 10. In this case, the raw material melting furnace 10 may be configured to be movable toward the crystal growing furnace. Further, the end the hose-structure portion 21 which is nearer the crystal growing furnace 9 has an interruption function (corresponding to a supply port of the invention), for example, a coupling/decoupling valve so as to decouple the crystal pull-up furnace 9 and the raw material melting furnace 10 from each other while the supply tube 22 is accommodated inside the raw material melting furnace 10. Then, when the raw material furnace 10 is rotated by a predetermined angle, the molten raw material 3 may be supplied to each of four crystal pull-up furnaces 9. Even in this case, the coupling and decoupling may be freely performed by forming an air lock structure at the time of coupling.

In addition, each of the crystal pull-up furnaces 9 and the raw material melting furnace 10 is provided with a pressure reduction valve (not shown) for adjusting the amount of discharged air inside the furnace, and the pressure inside the furnace may be adjusted by changing an opening/closing degree of the pressure reduction valve.

A crystal growing method using the crystal growing apparatus with the above-described configuration may be performed as the following sequences.

First, the raw material is melted in the raw material melting furnace 10, and the molten raw material 3 is produced before the step of growing the crystal. In the step of producing the molten raw material 3, the gate valve 15 is opened to charge the solid raw material into the hopper 13, and the gate valve 15 is closed. Then, the melting crucible 11 is heated under the presence of an inert gas to produce the molten raw material 3. Further, in the step of producing the molten raw material, the pressure of the raw material melting furnace 10 is set to be higher than a typical pressure when a crystal is growing, and is set to, for example, 3.33 kPa (25 torr) to 86.65 kPa (650 torr). Likewise, since the pressure in the raw material furnace 10 during the crystal growth is set to be slightly higher, the heat transfer from a heater may be improved. Besides, it is not desirable to heat the raw material to a high temperature to melt the raw material in a short time at 3.33 kPa (25 torr) or less because there is likeliness that bumping is generated. The adjustment of the pressure is performed by the use of the pressure reduction valve.

When the molten raw material 3 is produced, the raw material is continuously supplied to the quartz crucible 11. In this supply operation, the raw material melting furnace 10 is first coupled to the crystal pull-up furnace 9, of which the pressure is reduced in advance and which is under the presence of an inert gas, via the hose-structure portion 21. When the crystal pull-up furnace 9 and the raw material melting furnace 10 are coupled to each other, the pressure thereof is adjusted, so that the pressure and ambient conditions become equal to each other between the raw material melting furnace 10 and the crystal pull-up furnace 9. Subsequently, the coupling/decoupling valve is opened, and the trestle 23 is moved so that one end of the supply tube 22 is immersed in the molten raw material 3 of the melting crucible 11 and the other end thereof is disposed inside the quartz crucible 1. At this time, the location of the melting crucible 11 is adjusted to be higher than that of the quartz crucible 1, and the molten raw material 3 is supplied from the molten crucible 11 to the quartz crucible 1 by the use of a difference in the height between both crucibles 1 and 11. When the transparent quartz tube of the supply tube 22 is formed of silicon, it is desirable that the transparent quartz tube is maintained in the range from 1000[deg.]C to 1420[deg.]C. When the supply of the molten raw material ends, the trestle 23 is moved again so that the entire supply tube 23 is accommodated in the hose-structure portion 21 and the coupling/decoupling valve is closed. Then, the raw material melting furnace 10 is rotated so as to supply the molten raw material to the other crystal pull-up furnaces 9 in the same way.

Further, it is desirable to reduce the pressure of the crystal pull-up furnace 9 to be in the range of 1.33 kPa (10 torr) to 4.00 kPa (30 torr) to create a reduced pressure state in which SiO which is a source of causing discontinuous portions in the crystal can be smoothly exhausted. For this reason, in order to prevent a difference in the pressure between both furnaces 9 and 10 when the raw material melting furnace 10 and the crystal pull-up furnace 9 are coupled to each other, the pressure inside the raw material melting furnace 10 is equated to the pressure inside the crystal pull-up furnace 9, thereby preventing turbulence between the furnaces which is attributable to a difference in the pressure between the furnaces when the coupling/decoupling valve is opened or closed. Accordingly, after checking that the pressures of both furnaces 9 and 10 are equal to each other, the coupling/decoupling valve is opened or closed.

When the molten raw material 3 is supplied to the quartz crucible 1, the crystal 4 is continuously produced. In the step of producing the crystal, the crystal 4 is pulled up from the molten raw material 3 by using the pull-up mechanism 7 provided inside the vacuum chamber 2. Further, since the details thereof are the same as those of the CZ method that is generally known, the detailed description thereof will not be made. Furthermore, the crystal pull-up furnace 9 may be a vertical gradient freezing furnace (a VGF furnace) that is used to implement a vertical gradient freezing method (a VGF method). Even in this case, accidents involving the deformation or the breaking of the crystal growing furnace may be reduced. Thus, shortening of the melting time and working with safety may be easily achieved.

When the crystal 4 is completely produced, the crystal 4 is withdrawn finally. In the step of withdrawing the crystal, the sub-gate valve 6 of the vacuum chamber 2 is closed, so that extracting the crystal 4 from the vacuum chamber 2 can be performed while the quartz crucible 1 is maintained under the presence of an inert gas.

Subsequently, by repeating the crystal production process and the supply process, it is possible to produce the crystal 4 with a longer lifetime of the quartz crucible 1.

Generally, the molten raw material 3 is obtained by melting a polycrystalline solid raw material, but the molten raw material 3 is required to have extremely high purity. For this reason, it is desirable that the purity of the solid raw material as the base of the molten raw material is as high as possible. However, when the scrapes or the like generated upon processing the crystal 4 are recycled, the purity of the solid raw material may be inevitably low. In this case, an insoluble material containing impurities can be removed from the melting crucible 11, and the result may be supplied to the quartz crucible 1.

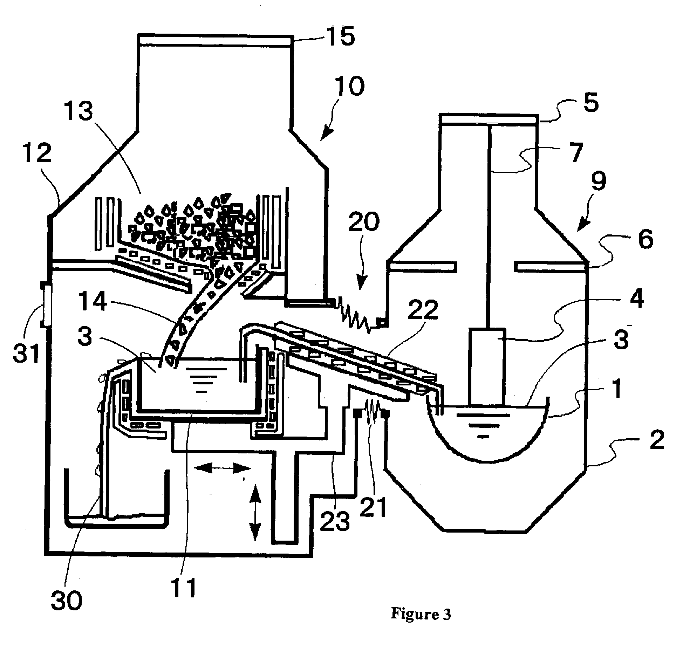

Fig. 3 illustrates a principle of removing the insoluble material. Since the insoluble material floats on the surface of the molten raw material 3, if a guide 30 is provided to discharge the insoluble material from the surface of the melting crucible 11, the insoluble material may be removed very easily. At this time, it is desirable to provide a monitor window 31 in order to check whether the insoluble material is removed.

Likewise, since the quartz crucible 1 is not used in melting the raw material but the raw material is melted in the melting crucible 11 separated from the quartz crucible 1, the quartz crucible 1 can be used for a longer period of time even in the case of using a raw material with low purity because the impurities can be removed.

## Claims

1. A crystal growing method, comprising:
• producing molten raw material in a raw material melting furnace (10) which is decoupled from a crystal growing furnace (9) having a quartz crucible (1) for crystal growth, wherein pressure of the raw material melting furnace (10) is set to be higher than the pressure of the crystal growing furnace (9) and is set not to generate bumping,
• adjusting the pressure of the raw material melting furnace (10) and the crystal growing furnace (9) to become equal to each other by reducing inside pressure of the raw material melting furnace (10) by means of a pressure reduction valve,
• opening a coupling/decoupling valve to couple the raw material melting furnace (10) and the crystal growing furnace (9),
• supplying molten raw material to the quartz crucible (1) by using a height difference between the quartz crucible (1) and a melting crucible (11) in the raw material melting furnace (10), wherein the melting crucible (11) is located higher than the quartz crucible (1), and
• decoupling the raw material melting furnace (10) from the crystal growing furnace (9) after the supplying.

2. The crystal growing method according to claim 1, wherein an insoluble material is removed from the molten raw material before the supplying.

## Patentansprüche

1. Kristallzüchtungsverfahren, umfassend:
• Herstellen eines geschmolzenen Rohmaterials in einem Rohmaterialschmelzofen (10), der von einem Kristallzüchtungsofen (9) mit einem Quarztiegel (1) für die Kristallzüchtung entkoppelt ist, wobei der Druck des Rohmaterialschmelzofens (10) höher eingestellt ist als der Druck des Kristallzüchtungsofens (9) und so eingestellt ist, dass ein Siedeverzug vermieden wird,
• Einstellen des Drucks des Rohmaterialschmelzofens (10) und des Kristallzüchtungsofens (9) auf den gleichen Wert durch Senken des Drucks im Rohmaterialschmelzofen (10) mittels eines Druckminderventils,
• Öffnen eines Kopplungs-/Entkopplungsventils zum Koppeln des Rohmaterialschmelzofens (10) und des Kristallzüchtungsofens (9),
• Fördern von geschmolzenem Rohmaterial in den Quarztiegel (1) durch Nutzen eines Höhenunterschied zwischen dem Quarztiegel (1) und einem Schmelztiegel (11) im Rohmaterialschmelzofen (10), wobei sich der Schmelztiegel (11) höher als der Quarztiegel (1) befindet, und
• Entkoppeln des Rohmaterialschmelzofens (10) vom Kristallzüchtungsofen (9) nach dem Fördern.

2. Kristallzüchtungsverfahren nach Anspruch 1, wobei vor dem Fördern ein unlösliches Material aus dem geschmolzenen Rohmaterial entfernt wird.

## Revendications

1. Procédé de cristallogenèse comprenant:
• la production de matière première fondue dans un four de fusion de matière première (10) qui est découplé d'un four de cristallogenèse (9) possédant un creuset en quartz (1) pour la croissance des cristaux, la pression du four de fusion de matière première (10) étant paramétrée pour être supérieure à la pression du four de cristallogenèse (9) et étant paramétrée pour ne pas générer de soubresauts,
• le réglage de la pression du four de fusion de matière première (10) et du four de cristallogenèse (9) afin qu'elles deviennent égales l'une à l'autre en réduisant la pression intérieure du four de fusion de matière première (10) à l'aide d'une vanne de détente,
• l'ouverture d'une vanne de couplage/découplage pour coupler le four de fusion de matière première (10) et le four de cristallogenèse (9),
• l'alimentation en matière première fondue du creuset en quartz (1) en utilisant une différence de hauteur entre le creuset en quartz (1) et un creuset de fusion (11) dans le four de fusion de matière première (10), le creuset de fusion (11) étant situé plus haut que le creuset en quartz (1), et
• le découplage du four de fusion de matière première (10) et du four de cristallogenèse (9) après l'alimentation.

2. Le procédé de cristallogenèse selon la revendication 1, dans lequel une matière insoluble est retirée de la matière première fondue avant l'alimentation.
